(19) Europäisches Patentamt / European Patent Office / Office européen des brevets

(11) **EP 3 342 789 B1**

(12) **EUROPEAN PATENT SPECIFICATION**

(45) Date of publication and mention
of the grant of the patent:
**02.06.2021 Bulletin 2021/22**

(21) Application number: **16838778.5**

(22) Date of filing: **09.08.2016**

(51) Int Cl.:
*C08F 2/44* (2006.01)          *B29C 67/00* (2017.01)
*B33Y 10/00* (2015.01)        *B33Y 30/00* (2015.01)
*B33Y 70/00* (2020.01)        *C08F 263/08* (2006.01)
*G03F 7/027* (2006.01)        *G03F 7/038* (2006.01)
*G03F 7/20* (2006.01)          *G03F 7/00* (2006.01)

(86) International application number:
**PCT/JP2016/003681**

(87) International publication number:
**WO 2017/033427 (02.03.2017 Gazette 2017/09)**

(54) **PATTERNING MATERIAL, PATTERNING METHOD AND PATTERNING DEVICE**

STRUKTURIERUNGSMATERIAL, STRUKTURIERUNGSVERFAHREN UND STRUKTURIERUNGSVORRICHTUNG

MATÉRIAU, PROCÉDÉ ET DISPOSITIF DE FORMATION DE MOTIF

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.08.2015 JP 2015167157**

(43) Date of publication of application:
**04.07.2018 Bulletin 2018/27**

(73) Proprietor: **Nagase ChemteX Corporation
Osaka-shi, Osaka 550-8668 (JP)**

(72) Inventor: **WATANABE, Koji
Tatsuno-shi
Hyogo 679-4124 (JP)**

(74) Representative: **Weal, Emily Teresa et al
Keltie LLP
No.1 London Bridge
London SE1 9BA (GB)**

(56) References cited:
**EP-A1- 1 902 829          WO-A1-2015/137504
GB-A- 991 171          JP-A- 2011 074 253
JP-A- 2015 150 761          JP-A- 2015 174 919**

**Description**

[Technical Field]

The present invention relates to a patterning material for three-dimensional stereolithography that is liquid at room temperature, and a patterning method and a patterning apparatus that use the patterning material.

[Background Art]

Various exposure methods are used in three-dimensional stereolithography such as 3D printers. In particular, from the viewpoint of suppressing the amount of usage of patterning material, three-dimensional stereolithography that uses a surface exposure technique has been proposed. With the surface exposure technique, a layer of material is cured through surface exposure so as to form a two-dimensional pattern, which is repeated in the height direction so as to form a three-dimensionally shaped article.

As a patterning material suitable for this technique, Patent Literature 1 proposes a resin composition that contains a dimethacrylate compound. Also, as a photocurable material for stereolithography, Patent Literature 2 proposes a material that contains a triepoxy compound.

[Citation List]

[Patent Literatures]

[PTL 1] Laid-Open Patent Publication No. 2008-189782
[PTL 2] Laid-Open Patent Publication No. 2010-265408

European Patent Application No. 1 902 829 A1 in the name of Cmet Inc. refers in paragraph [0001] thereof to "*a three-dimensional object including a plurality of cured resin layers stacked, having a predetermined shaped pattern formed by irradiating a fabricating surface of an actinic radiation-curable resin composition with an actinic radiation ray; an actinic radiation-curable resin composition for manufacturing the three-dimensional object; and a manufacturing method of the three-dimensional object*'.

UK Patent Publication No. 991 171 A in the name of Gestetner Ltd refers in the abstract thereof to "*[a]n ink suitable for impregnating a typewriter ribbon for use in imaging lithographic printing plates comprises a heat-polymerizable acrylic ester monomer, di-allyl phthalate monomer or di-allyl isophthalate monomer*".

Japanese Patent Publication No. 2015 150761 A in the name Cmet Inc refers, according to a machine translation of the abstract thereof, to "*[a]n optical modeling method, an optical modeling apparatus, and slice data for suppressing deformation of each layer of a three-dimensional shape having a crosslinked structure at the time of curing are provided*'.

[Summary of Invention]

[Technical Problem]

Three-dimensional stereolithography is required to, in addition to improving the curing speed, suppress a shrinkage of the shaped article. From the viewpoint of improving the stereolithography speed and the characteristics of the shaped article, selection of a material is also important. With the surface exposure technique, it is difficult to control the amount of light, and the optical path length and it is therefore difficult to design a photocurable material that can be cured at a high curing speed. Also, if a shrinkage occurs in the shaped article during photocuring, the reproducibility and the dimensional accuracy of the shaped article may decrease, and warping may occur.

It is an object of the present invention to provide a patterning material for three-dimensional stereolithography, a patterning method and a patterning apparatus, with which it is possible to improve the curing speed and suppress a shrinkage of the three-dimensionally shaped article.

[Solution to Problem]

An aspect of the present invention relates to a patterning material for three-dimensional stereolithography including: a diallyl phthalate prepolymer; a photocurable monomer; and a photopolymerization initiator, wherein the patterning material is liquid at room temperature.

Another aspect of the present invention relates to a patterning method for forming a three-dimensionally shaped pattern by irradiating the above-described patterning material with light, the method including the steps of:

(i) supplying the patterning material in a form of a liquid onto a pattern forming surface of a platform so as to form a liquid film of the patterning material, and exposing the liquid film to light so as to photocure the liquid film, thereby forming a pattern;
(ii) supplying the patterning material between the pattern and a light source so as to further form an additional liquid film; and
(iii) exposing the additional liquid film to light from the light source so as to photocure the additional liquid film, thereby laminating an additional pattern on the pattern.

Still another aspect of the present invention relates to a patterning apparatus for forming a three-dimensionally shaped pattern by using the above-described patterning material, the patterning apparatus including:

a platform having a pattern forming surface;
a supply unit that supplies the patterning material in a form of a liquid such that a liquid film of the patterning material is formed on the pattern forming surface; and
a light source for exposing the liquid film to light so as to photocure the liquid film.

[Advantageous Effects of Invention]

According to the present invention, it is possible to improve the curing speed during three-dimensional stereolithography and suppress a shrinkage of the shaped article.
A novel feature of the present invention is set forth in the appended claims, but the present invention will be more clearly understood, in terms of both configuration and content, from the detailed description given below with reference to the accompanying drawings together with other objects and features of the present invention.

[Brief Description of Drawing]

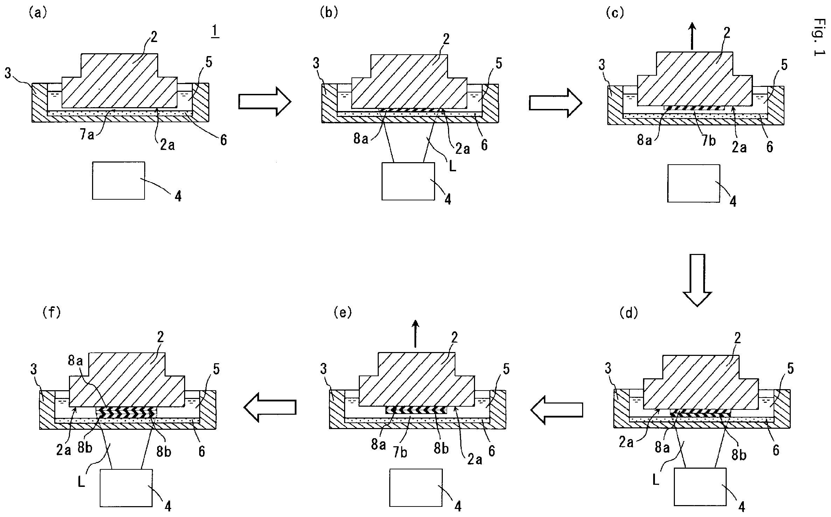

[FIG. 1] FIG. 1 is a schematic diagram illustrating the steps of a patterning method used in three-dimensional stereolithography according to an embodiment of the present invention.

[Description of Embodiment]

[Patterning Material for Three-Dimensional Stereolithography]

A patterning material for three-dimensional stereolithography according to an embodiment of the present invention contains a diallyl phthalate prepolymer, a photocurable monomer and a photopolymerization initiator, and is liquid at room temperature. Such a patterning material is a photocurable material.
Conventionally, three-dimensional stereolithography uses a point exposure technique in which a shaped article is produced by irradiating, pointwise, a photocurable material in the form of a powder or a liquid with high-energy laser light. However, in this case, it takes a long time to produce the shaped article. To address this, from the viewpoint of shortening the time required for shaping, the three-dimensional stereolithography that uses a surface exposure technique is increasingly used. With the surface exposure technique, however, the amount of light irradiated to the material tends to be small. For this reason, the surface exposure technique is required to further improve the curing speed.
Also, with the surface exposure technique, it is difficult to control the amount of light and the optical path length, and it is therefore difficult to more uniformly cure the material at a high curing speed. Accordingly, a shrinkage may occur in the shaped article during photocuring, which may cause warping or reduce the shape reproducibility and the dimensional accuracy. The effect of shrinkage of the shaped article poses little problem in the case of a two-dimensional pattern. However, the effect of shrinkage of the shaped article becomes pronounced in three-dimensional stereolithography.
In the present embodiment, as a result of the patterning material having the above-described composition, it is possible to cause photocuring to proceed efficiently. Accordingly, it is possible to improve the curing speed. In addition, with the use of the diallyl phthalate prepolymer, the shrinkage of the shaped article obtained through three-dimensional stereolithography can be suppressed significantly. Accordingly, the reduction in the reproducibility and the dimensional accuracy of the shaped article as well as the warping of the shaped article can be suppressed.
The stereolithography that uses a surface exposure technique is also called a plane exposure stereolithography that is a stereolithography method in which a predetermined plane of a patterning material is irradiated with light at a time so as to cure the plane irradiated with the light in a lump.

(Diallyl Phthalate Prepolymer)

The diallyl phthalate prepolymer refers to an oligomer or a polymer in which a plurality of diallyl phthalate units are connected and whose molecular weight can be further increased through photopolymerization. With the use of the diallyl phthalate prepolymer, it is possible to cause the curing reaction of the patterning material to proceed rapidly and suppress the shrinkage at the time of curing.

There is no particular limitation on the position of two allyloxycarbonyl groups in a diallyl phthalate unit. They may be positioned at the ortho position (1,2-position), the meta position (1,3-position), or the para position (1,4-position). The diallyl phthalate prepolymer may include one kind of diallyl phthalate unit, or may include two or more kinds of diallyl phthalate units. Examples of the two or more kinds of diallyl phthalate units include a plurality of diallyl phthalate units having different substituted positions of allyloxycarbonyl groups. It is also possible to use an ortho-form diallyl phthalate prepolymer that includes a connecting chain of o-diallyl phthalate units, or an iso-form diallyl phthalate prepolymer that includes a connecting chain of m-diallyl phthalate units.

The diallyl phthalate prepolymer has a weight-average molecular weight of, for example, 5,000 to 150,000, and preferably 10,000 to 120,000, or 30,000 to 100,000. When the weight-average molecular weight is within the above range, the shrinkage at the time of curing is easily suppressed, and a high curing speed is easily ensured.

The proportion of the diallyl phthalate prepolymer in the total amount of the diallyl phthalate prepolymer and the photocurable monomer is preferably 5 to 40 mass% or 5 to 35 mass%, and more preferably 10 to 35 mass%. From the viewpoint of ease of further suppression of the shrinkage at the time of curing, it is more preferable that the proportion of the diallyl phthalate prepolymer is 25 to 35 mass%.

The amount of the diallyl phthalate prepolymer in the patterning material is preferably, for example, 5 to 40 mass%.

(Photocurable Monomer)

As the photocurable monomer, a monomer that can be cured (or polymerized) by the action of radicals, or ions generated by light irradiation is used. As the photocurable monomer, it is preferable to use a multifunctional monomer having a plurality of polymerizable functional groups. The number of the polymerizable functional groups in the photocurable monomer may be, for example, 2 to 8, or may be 3 to 6. Examples of the polymerizable functional groups include groups having a polymerizable carbon-carbon unsaturated bond such as vinyl group and allyl group, and epoxy group.

As the photocurable monomer, for example, it is possible to use a radically polymerizable monomer such as an acrylic monomer, a cationically polymerizable monomer such as an epoxy-series monomer or a vinyl-series monomer. The photocurable monomer may be composed of a single photocurable monomer or a combination of two or more photocurable monomers. With the use of the radically polymerizable monomer such as an acrylic monomer, the polymerization reaction proceeds easily, and a high curing speed is obtained with ease. However, when three-dimensional stereolithography is performed by using the radically polymerizable monomer such as an acrylic monomer, volume shrinkage at the time of curing is likely to be large. The patterning material according to the present embodiment contains the diallyl phthalate prepolymer, and therefore even when the radically polymerizable monomer such as an acrylic monomer is used, the shrinkage at the time of curing can be suppressed, and a high curing speed can be maintained.

As the acrylic monomer, for example, a (meth) acrylic acid ester of a polyol is used. The polyol may be, for example, an aliphatic polyol, or may have an aromatic ring or an aliphatic ring. In this specification, acrylic acid esters and methacrylic acid esters are collectively referred to as (meth) acrylic acid esters or (meth) acrylates.

Examples of the (meth) acrylic acid ester of the aliphatic polyol include ethylene glycol di(meth)acrylate, trimethylolpropane tri(meth)acrylate, pentaerythritol tetra(meth)acrylate, and dipentaerythritol hexa(meth)acrylate.

Examples of the (meth) acrylic acid ester of the polyol having an aromatic ring include a di(meth)acrylate of a bisphenol, and a di(meth)acrylate of an alkylene oxide adduct of a bisphenol. Examples of the alkylene oxide include ethylene oxide and propylene oxide. The amount of the alkylene oxide added per mole of the bisphenol is, for example, 1 to 6 mol, and preferably 1 to 4 mol. Examples of the di(meth)acrylate of the bisphenol include bisphenol A di(meth)acrylate. Examples of the di(meth)acrylate of the alkylene oxide adduct of the bisphenol include ethoxylated bisphenol A di(meth)acrylate, propoxylated bisphenol A di(meth)acrylate, and ethoxy-propoxylated bisphenol A di(meth)acrylate.

Examples of the (meth) acrylic acid ester of the polyol having an aliphatic ring include, in addition to a (meth) acrylic acid ester of a hydrogenated product of a polyol having an aromatic ring described above, cyclohexane diol di(meth)acrylate, cyclohexane dimethanol di(meth)acrylate, and tricyclodecane dimethanol di(meth)acrylate. The aliphatic ring may be a single ring, or may be a bridged ring such as a bicyclo ring or a tricyclo ring.

As the vinyl-series monomer, it is preferable to use a vinyl ether such as polyol poly(vinylether). As the polyol that constitutes the polyol poly(vinylether), the polyols listed for the acrylic monomer can be used. Specific examples of the polyol poly(vinylether) include ethylene glycol divinyl ether, triethylene glycol divinyl ether, trimethylol propane trivinyl ether, pentaerythritol tetravinyl ether, cyclohexane diol divinyl ether, and cyclohexane dimethanol divinyl ether.

As the epoxy-series monomer, it is possible to use a compound having two or more epoxy groups within a molecule. The epoxy-series monomer may have, for example, an epoxycyclohexane ring or a 2,3-epoxypropyloxy group. Examples of the epoxy-series monomer having an epoxycyclohexane ring include 3,4-epoxycyclohexylmethyl 3,4-epoxycyclohexanoate (CELLOXIDE 2021P available from Daicel Corporation), 1-(1,2-epoxy-2-propanyl)-3-methyl-3,4-epoxycyclohexane (CELLOXIDE 3000 available from Daicel Corporation), 3,4-epoxycyclohexane acid ester (CELLOXIDE 2081 available from Daicel Corporation).

(Photopolymerization Initiator)

The photopolymerization initiator is activated by the action of light, and initiates polymerization of the diallyl phthalate prepolymer and/or the photocurable monomer. Examples of the photopolymerization initiator include, in addition to a radical polymerization initiator that generates radicals by the action of light, an agent that produces a base (or anion) by the action of light and an agent that produces an acid (or cation) by the action of light (specifically, an anion generator and a cation generator). The photopolymerization initiators may be composed of a single photopolymerization initiator or in a combination of two or more photopolymerization initiators. The photopolymerization initiator may be selected according to the type of photocurable monomer, for example, whether the photocurable monomer is radically polymerizable or ionically polymerizable. Where necessary, the photopolymerization initiator may be a combination of a radical polymerization initiator with an anion generator or a cation generator.

From the viewpoint of ease of obtaining a high curing speed, it is preferable to use a radical polymerization initiator as the photopolymerization initiator. In particular, it is desirable to use a radically polymerizable monomer such as an acrylic monomer and a radical polymerization initiator in combination. Examples of the radical polymerization initiator (radical photopolymerization initiator) include an alkylphenone-based photopolymerization initiator, and an acylphosphine oxide-based photopolymerization initiator.

Examples of the alkylphenone-based photopolymerization initiator include benzyldimethylketal, $\alpha$-hydroxyalkyl phenones, and $\alpha$-aminoalkyl phenones. Examples of the $\alpha$-aminoalkyl phenones include 2-methyl-1-(4-methylthiophenyl)-2-morpholinopropan-1-one, and 2-(dimethylamino)-2-[(4-methylphenyl)methyl]-1-[4-(4-morpholinyl)phenyl]-1-butanone. Examples of the acylphosphine oxide-based photopolymerization initiator include 2,4,6-trimethylbenzoyl-diphenyl-phosphine oxide, and bis(2,4,6-trimethylbenzoyl)-phenylphosphine oxide.

The amount of the photopolymerization initiator is preferably 0.5 to 20 parts by mass, and may be 1 to 15 parts by mass or 1 to 10 parts by mass relative to 100 parts by mass of the total amount of the diallyl phthalate prepolymer and the photocurable monomer. The amount of the photopolymerization initiator within the above range is advantageous in that the curing reaction is easily initiated with high efficiency and the curing speed is increased. From the viewpoint of obtaining a great effect of increasing the curing speed, it is also preferable to set the amount of the photopolymerization initiator to 3 to 15 parts by mass or 3 to 10 parts by mass.

(Thiol Compound)

The patterning material may further contain a thiol compound. In this case, an ene-thiol reaction occurs between the mercapto group of the thiol compound and the carbon-carbon double bond of the diallyl phthalate prepolymer and/or the photocurable monomer, and thus the curing speed can be further increased.

The thiol compound may be a monofunctional compound having one mercapto group, but from the viewpoint of ease of increasing the curing speed, the thiol compound is preferably a multifunctional compound having two or more mercapto groups. The number of mercapto groups in the multifunctional thiol compound is, for example, 2 to 8, and preferably 2 to 6 or 2 to 4.

As the thiol compound, it is possible to use a thiol, or a mercaptocarboxylic acid. However, from the viewpoint of high reactivity with the diallyl phthalate prepolymer and/or the photocurable monomer, it is preferable to use an ester of a mercaptocarboxylic acid and a polyol.

The thiol compound may be composed of a single compound or a combination of two or more compounds.

As the polyol that constitutes the ester described above, the polyols listed for the acrylic monomer can be used. Among them, it is preferable to use an aliphatic polyol. Specific examples of the aliphatic polyol include ethylene glycol, diethylene glycol, trimethylolpropane, pentaerythritol, and dipentaerythritol. In particular, it is preferable to use a $C_{2-10}$ aliphatic polyol or a $C_{2-6}$ aliphatic polyol.

As the mercaptocarboxylic acid that constitutes the ester, a mercapto aliphatic carboxylic acid such as a mercapto acetic acid, a mercapto propionic acid and a mercapto butanoic acid can be used. In particular, it is preferable to use a mercapto $C_{2-6}$ aliphatic carboxylic acid.

The amount of the thiol compound is, for example, 0.1 to 20 parts by mass, preferably 1 to 15 parts by mass or 1 to 10 parts by mass relative to 100 parts by mass of the total amount of the diallyl phthalate prepolymer and the photocurable monomer.

(Others)

The patterning material according to the present embodiment is liquid at room temperature. For this reason, it is possible to cause curing to proceed more uniformly and achieve a high level of shape reproducibility. As used herein, the term "room temperature" in this specification refers to, for example, a temperature of 20 to 35°C.

In general, a patterning material that contains a polymeric component such as a prepolymer has a viscosity higher than that containing only a monomer as a polymerizable component. For this reason, the material does not uniformly spread to where shaping needs to be performed, which may cause a defect in the shaped article. Also, as a result of air being mixed into the material, a defective shaped article may be produced. However, with the patterning material that contains the diallyl phthalate prepolymer, the viscosity does not increase so significantly, and it is therefore possible to reduce a defect in the shaped article as well as a shaping defect.

The patterning material may further contain any other known curable resin (excluding the diallyl phthalate prepolymer and the photocurable monomer). The proportion of the curable resin excluding the diallyl phthalate prepolymer and the photocurable monomer is preferably, for example, less than 50 mass% of the total amount of the curable components in the patterning material, and may be 30 mass% or less. From the viewpoint of ease of ensuring a high curing speed, the proportion of the curable resin is preferably 10 mass% or less of the total amount of the curable components in the patterning material, or 5 mass% or less.

The patterning material may further contain a known additive.

The patterning material has a viscosity at 25°C of, for example, 100 mPa to 15,000 mPa, and preferably 500 mPa to 10,000 mPa. When the patterning material has a viscosity within the above range, it is possible to enhance the workability.

The viscosity can be measured, for example, with a rotation speed of 10 rpm by using a cone-plate E type viscometer.

The patterning material according to the present embodiment may be patterned by using a light source for a point exposure technique. In general, with the surface exposure technique, the area of the liquid film of the patterning material irradiated with a single instance of light irradiation is larger than that in the case of the point exposure technique, but the amount of light irradiated per unit area is small. For this reason, the surface exposure technique is required to further improve the curing speed. On the other hand, according to the present embodiment, it is possible to increase the speed of the curing reaction of the patterning material, and thus a high curing speed can be ensured even with the use of the surface exposure technique. Accordingly, the patterning material according to the present embodiment is particularly suitable for use in patterning performed by surface exposure.

[Patterning Method (Method for Producing Three-Dimensionally Shaped Pattern) and Patterning Apparatus]

A patterning method according to an embodiment of the present invention is a patterning method for forming a three-dimensionally shaped pattern by irradiating the above-described patterning material with light from a light source. The patterning method includes: a step (i) of forming a pattern by using the above-described patterning material; a step (ii) of forming a liquid film of the patterning material between the pattern and the light source; and a step (iii) of curing the liquid film on the pattern and laminating an additional pattern.

A patterning apparatus according to an embodiment of the present invention is an apparatus for forming a three-dimensionally shaped pattern by using the above-described patterning material.

The patterning apparatus includes a platform having a pattern forming surface; a supply unit that supplies the patterning material onto the pattern forming surface; and a light source for photocuring a liquid film of the patterning material.

FIG. 1 is a schematic diagram illustrating the steps of the patterning method. FIG. 1 also schematically shows an example of the patterning apparatus.

Hereinafter, the steps of the patterning method and the constituent units of the patterning apparatus will be described in further detail with reference to the drawings as appropriate. There is no particular limitation on the exposure technique for forming patterns, and the method can be performed by using point exposure or surface exposure.

(i) Step of Forming Pattern

In the step (i), the patterning material in the form of a liquid is supplied onto the pattern forming surface of the platform so as to form a liquid film of the patterning material. Then, the liquid film is exposed to light so as to photocure the liquid film, and a pattern is thereby formed.

The patterning apparatus for forming a pattern includes a platform on which a three-dimensionally shaped article is formed. The platform has a pattern forming surface. A three-dimensionally shaped article is formed by sequentially laminating patterns on the pattern forming surface. There is no particular limitation on the shape, material, and size of the platform as long as the platform has a pattern forming surface.

In the step (i), first, a liquid film of the patterning material is formed on the pattern forming surface.

There is no particular limitation on the method for supplying the patterning material and the supply unit that supplies the patterning material as long as it is possible to form a liquid film on the pattern forming surface, and the method for supplying the patterning material and the supply unit that supplies the patterning material can be selected as appropriate according to the configuration of the patterning apparatus used. As used herein, the liquid film encompasses, in addition to a liquid film formed directly on the pattern forming surface, an additional liquid film that is formed via the pattern (and an additional pattern) that has been formed on the pattern forming surface.

For example, the liquid film may be formed by immersing the pattern forming surface in the patterning material that is contained in a resin bath (or in other words, the patterning material may be supplied to the pattern forming surface). In this case, the patterning apparatus includes, for example, the resin bath as the supply unit that supplies the patterning material. The patterning material may be supplied by applying the patterning material onto the pattern forming surface (or in other words, a liquid film may be formed). In this case, the patterning apparatus includes a coater that applies the patterning material. The supply unit may further include a cartridge that supplies the patterning material to the resin bath or the coater.

There is no particular limitation on the thickness of the liquid film as long as a pattern can be formed by exposing the liquid film to light and curing the liquid film. The liquid film has a thickness of, for example, 5 to 300 $\mu$m, and preferably 15 to 150 $\mu$m. When the liquid film has a thickness within the range, the curing reaction proceeds easily, and the shrinkage at the time of curing is easily suppressed.

In the step (ii), after the liquid film has been formed, light irradiation is performed by applying light from a light source to the liquid film so as to photocure the liquid film. The light irradiation can be performed by using a known method. As the light source, a known light source for photocuring can be used. In the case of the surface exposure technique, it is convenient to use a projector as the light source. Examples of the projector include an LCD (transmissive liquid crystal) projector, an LCoS (reflective liquid crystal) projector, and a DLP (registered trademark, Digital Light Processing) projector. Among them, it is preferable to use a DLP projector as the light source because the apparatus can be designed at a low cost. This is because a commercially available DLP projector can be used, and by removing the color filter, it is possible to easily emit light on the low wavelength side that has higher energy.

The exposure wavelength can be selected as appropriate according to the constituent components (in particular, the type of photopolymerization initiator) of the patterning material. In the case where the radical polymerization initiator is used, exposure can be performed by using light having a wavelength of, for example, 300 to 450 nm.

FIG. 1 shows an example of forming a three-dimensionally shaped pattern by using a patterning apparatus that includes a resin bath. A patterning apparatus 1 includes a platform 2 that has a pattern forming surface 2a, a resin bath 3 that contains a patterning material 5, and a projector 4 that is a light source for surface exposure technique. In the step (i), as shown in (a), first, the pattern forming surface 2a of the platform 2 is immersed in the patterning material 5 contained in the resin bath 3, with the pattern forming surface 2a facing toward the projector 4 (or in other words, toward the bottom surface of the resin bath 3). At this time, the height of the pattern forming surface 2a (or the platform 2) is adjusted such that a liquid film 7a is formed between the pattern forming surface 2a and the projector 4 (or the bottom surface of the resin bath 3). Then, as shown in (b), light L is emitted (surface exposure) from the projector 4 toward the liquid film 7a so as to photocure the liquid film 7a and form a pattern 8a.

In the patterning apparatus 1 shown in FIG. 1, the resin bath 3 functions as the supply unit that supplies the patterning material 5. In order to irradiate the liquid film with light from the light source, it is desirable that at least a portion of the resin bath, the portion being located between the liquid film and the projector 4 (the bottom surface in the example shown in the diagram), is transparent to the exposure wavelength.

(ii) Step of Forming Liquid Film between Pattern and Light Source

In the step (ii), an additional liquid film is formed by supplying the patterning material between the pattern formed in the step (i) and the light source. That is, the additional liquid film is formed on the pattern that has been formed on the pattern forming surface.

The patterning material can be supplied by using the method described in the step (i).

The thickness of the additional liquid film can be set as appropriate within the range mentioned for the liquid film in the step (i).

For example, in the step (ii), as shown in (c) in FIG. 1, after the pattern 8a has been formed, the pattern forming surface 2a may be moved upward together with the platform 2. Then, by supplying the patterning material 5 between the pattern 8a and the bottom surface of the resin bath 3, an additional liquid film 7b can be formed.

As described above, the patterning apparatus may further include, where necessary, a unit that moves the platform upward or downward such that a liquid film of the patterning material is formed between the light source and the pattern forming surface. For example, in the case where a liquid film is formed by immersing the pattern forming surface in the patterning material, as a result of providing the unit that moves the platform upward or downward, a liquid film having an appropriate thickness can be easily formed.

In addition, a release agent layer 6 may be formed on the inner bottom surface of the resin bath 3 so as to facilitate the release of the pattern 8a from the bottom surface of the resin bath 3. The present invention is not limited thereto, and a release treatment may be performed on a region of the inner wall of the resin bath that makes contact with a liquid film to be cured, so as to facilitate the release of the cured pattern.

(iii) Step of Laminating Additional Pattern on Pattern

In the step (iii), the additional liquid film formed in the step (ii) is exposed to light from the light source so as to photocure the additional liquid film and laminate an additional pattern (a pattern formed by photocuring the additional liquid film) on the pattern. As a result of patterns being laminated in the thickness direction in the manner described above, a three-dimensionally shaped pattern can be formed.

For example, as shown in (d) in FIG. 1, the additional liquid film 7b formed between the pattern 8a and the bottom surface of the resin bath 3 is exposed to light from the projector 4 so as to photocure the additional liquid film 7b. Through the photocuring, the additional liquid film 7b is converted to an additional pattern 8b. In this way, the additional pattern 8b can be laminated on the pattern 8a.

The light source, and the exposure wavelength are the same as those used in the step (i).

(iv) Step of Repeating Step (ii) and Step (iii)

The patterning method may include a step (iv) of repeating the step (ii) and the step (iii) a plurality of times. By performing the step (iv), a plurality of patterns b are laminated in the thickness direction, and a further built-up three-dimensionally shaped pattern can be obtained. The number of repetitions can be determined as appropriate according to the desired shape, and size of the three-dimensionally shaped pattern.

For example, as shown in (e) in FIG. 1, the platform 2 having the pattern 8a and the additional pattern 8b laminated on the pattern forming surface 2a is moved upward. At this time, an additional liquid film 7b is formed between the additional pattern 8b and the bottom surface of the resin bath 3. Then, as shown in (f) in FIG. 1, the additional liquid film 7b is exposed to light from the projector 4 so as to photocure the additional liquid film 7b. As a result, a further additional pattern 8b is formed on the additional pattern 8b. Then, by alternately repeating (e) and (f), a plurality of patterns 8b can be laminated.

(v) Step of Cleaning Three-Dimensionally Shaped Pattern

The three-dimensionally shaped pattern obtained in the step (iii) or the step (iv) has the patterning material adhering thereto, the patterning material containing components such as an uncured monomer and diallyl phthalate prepolymer. For this reason, normally, a cleaning treatment is performed. In the cleaning step (v), a solvent is used to remove the patterning material adhering to the three-dimensionally shaped pattern.

Unlike the monomer component, it is difficult to clean the diallyl phthalate prepolymer with the use of a commonly used solvent such as ethanol. For this reason, as the solvent for cleaning, it is preferable to use a solvent having a solubility parameter (sp) value of 8 to 11. By using such a solvent, it is possible to cleanly remove the patterning material. The solvent may be composed of a single solvent or a combination of two or more solvents.

As the solvent, it is preferable to use a solvent having a hydroxyl group and an ether group, or a solvent having an acetyl group. Specific examples of the former solvent include 3-methoxybutanol, propylene glycol monomethylether, propylene glycol n-propyl ether, propylene glycol n-butyl ether, dipropylene glycol monomethylether, and diethylene glycol monoethylether. Examples of the solvent having an acetyl group include methyl acetate, ethyl acetate, cyclohexanol acetate, ethylene glycol monomethylether acetate, propylene glycol methylether acetate, and propylene glycol diacetate. The sp value can be calculated by Fedors method.

(vi) Post-Curing Step

The three-dimensionally shaped pattern obtained in the step (iii), the step (iv) or the step (v) may be subjected to post-curing as needed. The post-curing can be performed by performing light irradiation to the pattern. The conditions for the light irradiation can be adjusted as appropriate according to the type of patterning material, and the degree of curing of the obtained pattern. The post-curing may be performed partially or entirely on the pattern.

[Examples]

Hereinafter, the present invention will be described specifically by way of examples and comparative examples, but the present invention is not limited to the examples given below.

Example 1

(1) Preparation of Patterning Material

A diallyl phthalate prepolymer (a1) (o-diallyl phthalate prepolymer, DAISO DAP K available from Daiso Industries Co., Ltd.), tricyclodecanedimethanol diacrylate (b2) (SR 833 available from Sartomer, Inc.) as a photocurable monomer, and 2-(dimethylamino)-2-[(4-methylphenyl)methyl]-1-[4-(4-morpholinyl)phenyl]-1-butanone (c1) (Irgacure 379 available from BASF) as a photo-radical polymerization initiator were mixed at a mass ratio shown in Table 1, and the resulting mixture was heated in an oven at 80°C so as to dissolve the solid components, and a homogeneous liquid patterning material was thereby prepared. The patterning material remained liquid even when cooled to 25°C.

(2) Evaluation

The following evaluation tests were performed on the patterning material obtained in (1) above.

(a) Viscosity

The viscosity of the patterning material was measured at 25°C by using an E type viscometer (TVE-20H available from Toki Sangyo Co., Ltd.) with a rotation speed of 10 rpm.

(b) Curing Speed

The patterning material was placed in a resin bath included in a patterning apparatus that includes a platform, the resin bath and a DLP projector as a light source. The platform was immersed, with its pattern forming surface facing downward, in the resin bath so as to form a liquid film (with a thickness of 150 $\mu$m) of the patterning material on the pattern forming surface. Then, surface exposure was performed on the liquid film by applying light from below the resin bath from the light source so as to cure the liquid film. Then, the irradiation dose required to completely cure the liquid film was used as an indication of the curing speed. The surface exposure was performed with a fixed illumination intensity of 0.2 mW/cm$^2$ and an exposure wavelength of 405 nm. The completion of curing was determined by touching, with a finger, the cured product of the liquid film formed on the pattern forming surface.

(c) Curing Shrinkage Rate

A pattern was formed by curing a liquid film on the pattern forming surface under the same exposure conditions as those used in (b) described above. Next, the pattern forming surface was moved upward, and an additional liquid film was formed on the surface of the pattern. Then, the additional liquid film was cured under the same exposure conditions as those described above, and an additional pattern was thereby laminated on the pattern. The pattern forming surface was again moved upward, a further additional liquid film was formed on the additional pattern and then cured under the same exposure conditions as those described above, and a further additional pattern was thereby laminated on the additional pattern. The step of laminating an additional pattern was repeated a plurality of times, and a three-dimensionally shaped pattern having a plate shape having a thickness of 300 $\mu$m was formed. Then, the cured product taken out of the resin bath was cleaned by using propylene glycol monomethylether, and thereafter subjected to post-curing in which both sides of the obtained plate were exposed to broadband light at 3 mJ/cm$^2$. Density $d_1$ of the patterning material before curing and density $d_2$ of the resulting three-dimensionally shaped pattern that had been post-cured were measured by using a gas density meter, and curing shrinkage rate (%) was obtained from the following equation:

$$\text{curing shrinkage (\%)} = (d_2 - d_1)/d_2 \times 100.$$

Examples 2 to 13 and Comparative Examples 1 to 5

Patterming materials were prepared in the same manner as in Example 1 except that the components shown in Table 1 were used in the amounts shown in Table 1, and then subjected to the evaluation tests. Examples 1 to 13 all form part of the invention.

The following components were used.

    (a) Diallyl Phthalate Prepolymer:

        (a1) o-diallyl phthalate prepolymer, DAISO DAP K available from Daiso Industries Co., Ltd.
        (a2) m-diallyl phthalate prepolymer, DAISO DAP ISO available from Daiso Industries Co., Ltd.

    (b) Photocurable Monomer

        (b1) radically polymerizable monomer: ethoxylated bisphenol A diacrylate (ethylene oxide 4 mol adduct, SR601 available from Sartomer, Inc.)
        (b2) radically polymerizable monomer: tricyclodecanedimethanol diacrylate (SR 833 available from Sartomer, Inc.)
        (b3) radically polymerizable monomer: dipentaerythritol hexaacrylate (DPHA available from Sartomer, Inc.)
        (b4) cationically polymerizable monomer: 3',4'-epoxycyclohexylmethyl-3,4-epoxycyclohexane carboxylate (epoxy-series monomer, CELLOXIDE 2021P available from Daicel Corporation)

    (c) Photopolymerization Initiator

        (c1) 2-(dimethyiamino)-2-[(4-methyiphenyl)methyl]-1-[4-(4-morpholinyl)phenyl]-1-butanone (Irgacure 379 available from BASF)
        (c2) 2,4,6-trimethylbenzoyl-diphenyl-phosphine oxide (Irgacure TPO available from BASF)
        (c3) sulfonium-based photo-cation generator (Irgacure 290 available from BASF)

    (d) Thiol Compound

        (d1) pentaerythritol tetrakis (3-mercaptobutyrate) (Karenz MT PE1 available from Showa Denko K.K.)
        (d2) pentaerythritol tetrakis (3-mercaptopropionate) (PEMP available from SC Organic Chemical Co., Ltd.)

    (e) Others
    (e1) dibutyl anthracene (photosensitizer, UVS-1331 available from Kawasaki Kasei Chemicals, Ltd.)

The results of evaluation tests obtained in the examples and the comparative examples are shown in Table 1 together with the formulations of the patterning materials of the examples and the comparative examples.

[Table 1]

| | Comparative Example | | | | | Example | | | | | | | | | | | | |
|---|---|---|---|---|---|---|---|---|---|---|---|---|---|---|---|---|---|---|
| | 1 | 2 | 3 | 4 | 5 | 1 | 2 | 3 | 4 | 5 | 6 | 7 | 8 | 9 | 10 | 11 | 12 | 13 |
| Diallyl phthalate prepolymer (part by mass) | | | | | | | | | | | | | | | | | | |
| a1 (DAISO DAP K) | | | | | | 30 | | | | | | | | | | | | |
| a2 (DAISO DAP ISO) | | | | | | | 30 | 30 | 20 | 10 | 30 | 30 | 30 | 30 | 30 | 30 | 30 | 30 |
| Photocurable monomer (part by mass) | | | | | | | | | | | | | | | | | | |
| b1 (SR601) | | | 100 | | 70 | | | 70 | | | | | | | | | | |
| b2 (SR 833) | | 100 | | | | 70 | 70 | | 80 | 90 | 70 | 70 | 70 | 70 | 70 | 70 | 70 | |
| b3 (DPHA) | 100 | | | | | | | | | | | | | | | | | |
| b4 (CELLOXIDE 2021P) | | | | 100 | 30 | | | | | | | | | | | | | 70 |
| Photopolymerization initiator (part by mass) | | | | | | | | | | | | | | | | | | |
| c1 (Irgacure 379) | 3 | 3 | 3 | | 2 | 3 | 3 | 3 | 3 | 3 | 3 | 3 | 3 | | 0.5 | 6 | 10 | 1 |
| c2 (Irgacure TPO) | | | | | | | | | | | | | | 3 | | | | |
| c3 (Irgacure 290) | | | | 3 | 1 | | | | | | | | | | | | | 2 |
| Thiol compound (part by mass) | | | | | | | | | | | | | | | | | | |
| d1 (KarenzMT PE1) | | | | | | | | | | | 3 | 10 | | 3 | | | | |
| d2 (PEMP) | | | | | | | | | | | | | 10 | | | | | |
| Others (part by mass) | | | | | | | | | | | | | | | | | | |
| Photosensitizer e1 (UVS-1331) | | | | 1 | 0.3 | | | | | | | | | | | | | |
| Viscosity (mPa) | 7800 | 150 | 1100 | 300 | 750 | 12000 | 8000 | 13000 | 2100 | 900 | 6800 | 5100 | 5000 | 6800 | 6600 | 7000 | 72000 | 11000 |

(continued)

| | Comparative Example | | | | | Example | | | | | | | | | | | | |
|---|---|---|---|---|---|---|---|---|---|---|---|---|---|---|---|---|---|---|
| | 1 | 2 | 3 | 4 | 5 | 1 | 2 | 3 | 4 | 5 | 6 | 7 | 8 | 9 | 10 | 11 | 12 | 13 |
| Irradiation dose (mJ/cm$^2$) | 6 | 6 | 6 | 40 | 18 | 3 | 3 | 3 | 4 | 5 | 1 | 1 | 1 | 2 | 6 | 2 | 1 | 15 |
| Curing shrinkage rate (%) | 11.9 | 8.3 | 7.1 | 4.6 | 6.1 | 4.5 | 4.3 | 3.8 | 5.5 | 7.2 | 4.1 | 4 | 4.1 | 4.1 | 4.1 | 4.1 | 4 | 3.6 |

As shown in Table 1, in the examples, a high curing speed was obtained with a less irradiation dose. Also, in the examples, the curing shrinkage rate was suppressed to a low level. In particular, in Examples 6 to 9 in which a thiol compound was used, the irradiation dose required for curing was low.

On the other hand, in Comparative Examples 1 to 3 in which a radically polymerizable monomer was used without using the diallyl phthalate prepolymer, the irradiation dose required for curing was higher than that used in Examples 1 to 12. Also, in Comparative Examples 1 and 2, the curing shrinkage rate was high. In Comparative Examples 4 and 5 in which a cationically polymerizable monomer was used without using the diallyl phthalate prepolymer, the irradiation dose required for curing was high, and the curing speed was low.

The present invention has been described by way of preferred embodiments at present, but the disclosure should not be construed as liming the scope of the present invention. Various variations and modifications will become clearly apparent to those skilled in the art to which the present invention pertains upon reading the disclosure given above.

[Industrial Applicability]

With the use of the patterning material according to the embodiment of the present invention, it is possible to obtain a high curing speed and suppress a shrinkage at the time of curing. Accordingly, the patterning material according to the embodiment of the present invention is suitable for use as the patterning material for three-dimensional stereolithography.

[Reference Signs List]

    1: patterning apparatus
    2: platform
    2a: pattern forming surface
    3: resin bath
    4: projector
    5: patterning material
    6: release agent layer
    7a: liquid film
    7b: additional liquid film
    8a: pattern
    8b: additional pattern
    L: light

**Claims**

1. A patterning material for three-dimensional stereolithography comprising:

   a diallyl phthalate prepolymer;
   a photocurable monomer; and
   a photopolymerization initiator,
   wherein the patterning material is liquid at room temperature.

2. The patterning material in accordance with claim 1,
   wherein the patterning material is patterned by using a surface exposure technique.

3. The patterning material in accordance with claim 1 or 2,
   wherein a proportion of the diallyl phthalate prepolymer in a total amount of the diallyl phthalate prepolymer and the photocurable monomer is 5 to 40 mass%.

4. The patterning material in accordance with any one of claims 1 to 3, further comprising a thiol compound.

5. The patterning material in accordance with any one of claims 1 to 4,
   wherein the photopolymerization initiator is a radical polymerization initiator.

**6.** The patterning material in accordance with any one of claims 1 to 5,
wherein the photocurable monomer contains a radically polymerizable monomer.

**7.** The patterning material in accordance with any one of claims 1 to 6,
wherein the patterning material has a viscosity at 25°C of 100 mPa to 15,000 mPa.

**8.** The patterning material in accordance with any one of claims 1 to 7,
wherein an amount of the photopolymerization initiator is 1 to 10 parts by mass relative to 100 parts by mass of a total amount of the diallyl phthalate prepolymer and the photocurable monomer.

**9.** A patterning method for forming a three-dimensionally shaped pattern by irradiating the patterning material in accordance with any one of claims 1 to 8 with light, the method comprising the steps of:

(i) supplying the patterning material in a form of a liquid onto a pattern forming surface of a platform so as to form a liquid film of the patterning material, and exposing the liquid film to light so as to photocure the liquid film, thereby forming a pattern;
(ii) supplying the patterning material between the pattern and a light source so as to further form an additional liquid film; and
(iii) exposing the additional liquid film to light from the light source so as to photocure the additional liquid film, thereby laminating an additional pattern on the pattern.

**10.** The patterning method in accordance with claim 9,
wherein the step (ii) and the step (iii) are repeated a plurality of times.

**11.** The patterning method in accordance with claim 10, further comprising a step of cleaning, using a solvent, a three-dimensionally shaped pattern obtained by repeating the step (ii) and the step (iii),
wherein the solvent has a sp value of 8 to 11.

**12.** A patterning apparatus for forming a three-dimensionally shaped pattern by using the patterning material in accordance with any one of claims 1 to 8, the patterning apparatus comprising:

a platform having a pattern forming surface;
a supply unit that supplies the patterning material in a form of a liquid such that a liquid film of the patterning material is formed on the pattern forming surface; and
a light source for exposing the liquid film to light so as to photocure the liquid film.

**Patentansprüche**

**1.** Musterbildungsmaterial für eine dreidimensionale Stereolithographie, das Folgendes umfasst:

ein Diallylphthalatprepolymer;
ein photochemisch härtbares Monomer; und
einen Initatior einer photochemischen Polymerisation,
wobei das Musterbildungsmaterial bei Raumtemperatur flüssig ist.

**2.** Musterbildungsmaterial nach Anspruch 1,
wobei das Musterbildungsmaterial durch Verwenden einer Oberflächenbelichtungstechnik mit einem Muster versehen wird.

**3.** Musterbildungsmaterial nach Anspruch 1 oder 2,
wobei ein Anteil des Diallylphthalatprepolymers in einer Gesamtmenge des Diallylphthalatprepolymers und des photochemisch härtbaren Monomers 5 bis 40 Massen-% beträgt.

**4.** Musterbildungsmaterial nach einem der Ansprüche 1 bis 3, das ferner eine Thiolverbindung umfasst.

**5.** Musterbildungsmaterial nach einem der Ansprüche 1 bis 4,
wobei der Initiator der photochemischen Polymerisation ein radikalischer Polymerisationsinitiator ist.

**6.** Musterbildungsmaterial nach einem der Ansprüche 1 bis 5,
wobei das photochemisch härtbare Monomer ein radikalisch polymerisierbares Monomer enthält.

**7.** Musterbildungsmaterial nach einem der Ansprüche 1 bis 6,
wobei das Musterbildungsmaterial bei 25 °C eine Viskosität von 100 mPa bis 15.000 mPa aufweist.

**8.** Musterbildungsmaterial nach einem der Ansprüche 1 bis 7,
wobei eine Menge des Initiators der photochemischen Polymerisation relativ zu 100 Massenteilen einer Gesamtmenge des Diallylphthalatprepolymers und des photochemisch härtbaren Monomers 1 bis 10 Massenteile beträgt.

**9.** Musterbildungsverfahren zum Ausbilden eines dreidimensional gestalteten Musters durch Bestrahlen des Musterbildungsmaterials nach einem der Ansprüche 1 bis 8 mit Licht, wobei das Verfahren die folgenden Schritte umfasst:

(i) Zuführen des Musterbildungsmaterials in einer Form einer Flüssigkeit auf eine musterausbildende Oberfläche einer Plattform, um einen Flüssigkeitsfilm des Musterbildungsmaterials auszubilden, und Belichten des Flüssigkeitsfilms mit Licht, um den Flüssigkeitsfilm photochemisch zu härten, wobei dadurch ein Muster ausgebildet wird;
(ii) Zuführen des Musterbildungsmaterials zwischen dem Muster und einer Lichtquelle, um ferner einen zusätzlichen Flüssigkeitsfilm auszubilden; und
(iii) Belichten des zusätzlichen Flüssigkeitsfilms mit Licht von der Lichtquelle, um den zusätzlichen Flüssigkeitsfilm photochemisch zu härten, wobei dadurch ein zusätzliches Muster auf das Muster geschichtet wird.

**10.** Musterbildungsverfahren nach Anspruch 9,
wobei der Schritt (ii) und der Schritt (iii) mehrere Male wiederholt werden.

**11.** Musterbildungsverfahren nach Anspruch 10, das ferner einen Schritt eines Reinigens, unter Verwendung eines Lösungsmittels, eines dreidimensional gestalteten Musters umfasst, das durch Wiederholen des Schritts (ii) und des Schritts (iii) erhalten wird,
wobei das Lösungsmittel einen sp-Wert von 8 bis 11 aufweist.

**12.** Musterbildungsvorrichtung zum Ausbilden eines dreidimensional gestalteten Musters durch Verwenden des Musterbildungsmaterials nach einem der Ansprüche 1 bis 8, wobei die Musterbildungsvorrichtung Folgendes umfasst:

eine Plattform, die eine musterausbildende Oberfläche aufweist;
eine Zuführeinheit, die das Musterbildungsmaterial in einer Form einer Flüssigkeit derart zuführt, dass ein Flüssigkeitsfilm des Musterbildungsmaterials auf der Musterausbildungsfläche ausgebildet wird; und
eine Lichtquelle zum Belichten des Flüssigkeitsfilms mit Licht, um den Flüssigkeitsfilm photochemisch zu härten.

**Revendications**

**1.** Matériau de formation de motif pour la stéréolithographie tridimensionnelle comprenant :

un prépolymère de phtalate de diallyle ;
un monomère photodurcissable ; et
un initiateur de photopolymérisation,
le matériau de formation de motif étant liquide à température de laboratoire.

**2.** Matériau de formation de motif selon la revendication 1,
le matériau de formation de motif étant formé en motifs en utilisant une technique d'exposition de surface.

**3.** Matériau de formation de motif selon la revendication 1 ou 2,
une proportion du prépolymère de phtalate de diallyle dans une quantité totale du prépolymère de phtalate de diallyle et du monomère photodurcissable étant de 5 à 40 % en masse.

**4.** Matériau de formation de motif selon l'une quelconque des revendications 1 à 3, comprenant en outre un composé thiol.

**5.** Matériau de formation de motif selon l'une quelconque des revendications 1 à 4,
l'initiateur de photopolymérisation étant un initiateur de polymérisation radicalaire.

**6.** Matériau de formation de motif selon l'une quelconque des revendications 1 à 5,
le monomère photodurcissable contenant un monomère polymérisable par voie radicalaire.

**7.** Matériau de formation de motif selon l'une quelconque des revendications 1 à 6,
le matériau de formation de motif ayant une viscosité à 25 °C de 100 mPa à 15 000 mPa.

**8.** Matériau de formation de motif selon l'une quelconque des revendications 1 à 7,
une quantité de l'initiateur de photopolymérisation étant de 1 à 10 parties en masse par rapport à 100 parties en masse d'une quantité totale du prépolymère de phtalate de diallyle et du monomère photodurcissable.

**9.** Procédé de formation de motif pour former un motif de forme tridimensionnelle en rayonnant le matériau de formation de motif selon l'une quelconque des revendications 1 à 8 avec de la lumière, le procédé comprenant les étapes consistant à :

(i) fournir le matériau de formation de motif sous une forme d'un liquide sur une surface de formation de motif d'une plateforme de manière à former un film liquide du matériau de formation de motif, et exposer le film liquide à la lumière de manière à photodurcir le film liquide, formant ainsi un motif ;
(ii) fournir le matériau de formation de motif entre le motif et une source de lumière de manière à former en outre un film liquide supplémentaire ; et
(iii) exposer le film liquide supplémentaire à la lumière provenant de la source de lumière de manière à photodurcir le film liquide supplémentaire, stratifiant ainsi un motif supplémentaire sur le motif.

**10.** Procédé de formation de motif selon la revendication 9,
l'étape (ii) et l'étape (iii) étant répétées une pluralité de fois.

**11.** Procédé de formation de motif selon la revendication 10, comprenant en outre une étape de nettoyage, à l'aide d'un solvant, d'un motif de forme tridimensionnelle obtenu en répétant l'étape (ii) et l'étape (iii),
le solvant ayant une valeur de paramètre de solubilité de 8 à 11.

**12.** Appareil de formation de motif permettant de former un motif de forme tridimensionnelle à l'aide du matériau de formation de motif selon l'une quelconque des revendications 1 à 8, l'appareil de formation de motif comprenant :

une plateforme ayant une surface de formation de motif ;
une unité de fourniture qui fournit le matériau de formation de motif sous la forme d'un liquide de telle sorte qu'un film liquide du matériau de formation de motif est formé sur la surface de formation de motif ; et
une source de lumière destinée à exposer le film liquide à la lumière de manière à photodurcir le film liquide.

Fig. 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008189782 A
- WO 2010265408 A
- EP 1902829 A1
- GB 991171A A
- JP 2015150761 A